# EUROPÄISCHE PATENTSCHRIFT

(11) **EP 4 185 730 B1**
(45) Veröffentlichungstag und Bekanntmachung des Hinweises auf die Patenterteilung: **01.05.2024**
(21) Anmeldenummer: 21754720.7
(22) Anmeldetag: 21.07.2021
(51) Int. Cl.: C23C 14/24, C23C 14/56, C23C 14/54

(54) **VERFAHREN ZUM ABSCHEIDEN VON METALLISCHEN WERKSTOFFEN**
METHOD FOR THE DEPOSITION OF METAL MATERIALS
PROCÉDÉ DE DÉPÔT DE MATÉRIAUX MÉTALLIQUES

(30) Priorität: 21.07.2020 DE 102020119155
(43) Veröffentlichungstag der Anmeldung: 31.05.2023
(73) Patentinhaber: voestalpine Stahl GmbH, 4020 Linz (AT)
(72) Erfinder: HAGLER, Josef, 4060 Leonding (AT); STELLNBERGER, Karl-Heinz, 4020 Linz (AT)
(74) Vertreter: HGF
(86) Internationale Anmeldenummer: PCT/EP2021/070378
(87) Internationale Veröffentlichungsnummer: WO 2022/018133

(56) Entgegenhaltungen:
- EP-A1- 0 477 474
- DE-B4-112005 001 190
- DE-C1- 3 439 001
- JP-A- H 024 963
- JP-A- S59 177 370

## Beschreibung

Die Erfindung betrifft ein Verfahren zum kontinuierlichem Abscheiden von Metallen und deren Legierungen, insbesondere von Zink und zinkhaltigen Legierungen auf Metallbändern, insbesondere Stahlbändern nach dem Oberbegriff des Anspruchs 1.

Die Oberflächenbeschichtung von metallischen Bauteilen und Komponenten hat in den letzten Jahren eine zunehmende Bedeutung erhalten. Insbesondere die kontinuierliche Schmelztauchveredelung von Flacherzeugnissen nach DIN EN 10346 hat aus Gründen des Korrosionsschutzes als Ausgangsmaterial für industrielle Anwendung, wie z.B. Herstellung von Karosserieteilen in der Automobilindustrie, eine herausragende Bedeutung erlangt.

Dabei wird Stahl kontinuierlich (z.B. Band und Draht) bei Temperaturen von etwa 450 °C bis 600 °C in eine Schmelze aus flüssigem Zink oder Zinklegierungen getaucht (der Schmelzpunkt von Zink liegt bei 419,5 °C). Die Zinkschmelze weist konventionell einen Zinkgehalt von mindestens 99% Massenanteile gemäß DIN EN 10346 auf. Zinklegierungen haben entsprechend niedrigere Gehalte an Zink. Eine kontinuierlich schmelztauchveredelte Stahlbandoberfläche weist eine Schichtdicke von 4 µm bis 45 µm auf.

Bei einer elektrolytischen Verzinkung (galvanischen Verzinkung) werden Stahlbänder oder Stahlplatten nicht in eine Zinkschmelze, sondern in einen Zinkelektrolyten eingetaucht. Dabei wird der zu verzinkende Stahl als Kathode geschalten und als Anode wird eine dimensionsstabile, unlösliche Elektrode verwendet. Durch die Elektrolytlösung wird ein Strom geleitet. Dabei wird das in ionischer Form vorliegende Zink (Oxidationsstufe +II) zu metallischem Zink reduziert und an der Stahloberfläche abgeschieden. Im Vergleich zur kontinuierliche Schmelztauchveredelung können durch eine elektrolytische Verzinkung dünnere Zinkschichten aufgetragen werden. Die Zinkschichtdicke ist dabei proportional zur Stärke und Zeitdauer des Stromflusses gemäß dem Faraday' schen Gesetz, wobei - abhängig von der Substrat- und Anodengeometrie - eine Schichtdickenverteilung über das gesamte Werkstück entsteht.

Es sind außerdem verschiedene PVD-Verfahren (physical vapour deposition, physikalische Gasphasenabscheidung) bekannt. Als PVD wird grundsätzlich ein vakuumbasiertes Beschichtungsverfahren bezeichnet, bei dem ein aufzutragendes Material in die Gasphase übergeführt und anschließend auf der zu beschichteten Oberfläche durch Kondensation/Sublimation abgeschieden wird. Die gebräuchlichsten PVD-Prozesse sind Sputtern und Verdampfen.

Beim Sputtern (auch als Kathodenzerstäubung bekannt) handelt es sich um einen physikalischen Vorgang, bei dem Atome aus einem Festkörper durch Beschuss mit energiereichen Ionen, vorwiegend Edelgasionen, herausgelöst und in die Gasphase überführt werden. Als Ionenquelle dient in den meisten Anwendungen eine Gleichstrom-Gasentladung. Bei einer einfachen Kathodenzerstäubung wird ein elektrisches Feld angelegt. Wird hinter der Kathodenplatte zusätzlich ein magnetisches Feld angeordnet, handelt es sich um ein Magnetronsputtern. In dieser Konfiguration können alle leitfähigen Materialien abgeschieden werden. Anders als beispielsweise beim thermischen Verdampfen tritt hier keine Entmischung von Legierungen auf. Auch ist die Haftung der Schichten meist besser als bei aufgedampften Beschichtungen, und es können große Flächen, wie z. B. Architekturglas, homogen beschichtet werden. Die Sputterdeposition ist eine der Standardbeschichtungstechniken und findet vielfältige Anwendung in der Industrie. Mit Sputterdepositionsverfahren werden hauptsächlich hochschmelzende Metalle abgeschieden, beispielsweise Titan, Wolfram und Nickel, aber auch Legierungen mit Nickelaluminium und bei Einleitung von reaktiven Gasen in die Beschichtungskammer auch Metalloxide, Nitride und Karbide.

Bei einem Verdampfungsverfahren kann es sich beispielsweise um thermisches Verdampfen, Elektronenstrahlverdampfen, Laserstrahlverdamfpen, Lichbogenverdampfen oder Molekularstrahlepitaxie und Mischformen dieser handeln. Dabei wird das abzuscheidende Material auf Temperaturen in der Nähe des Siedepunkts erhitzt, beispielsweise elektrisch, mittels Laser, Lichtbogen oder Ionenbeschuss. Der derart entstandene Materialdampf wandert durch eine Vakuumkammer zum Substrat und kondensiert/sublimiert an der Substratoberfläche, so dass eine dünne Materialschicht gebildet wird. Typische Materialien für diesen Prozess sind Metalle, z.B. Aluminium, Kupfer, Silber, Gold, oder auch andere Materialien, beispielsweise Siliziumoxid, Indiumoxid oder diverse organische Verbindungen. Beim Verdamfpen im Vakuum werden Drücke von 10⁻⁴ Pa bis 10 Pa benötigt. Der Prozess kann außerdem magnetisch unterstützt werden, indem geladene Materialteilchen (z.B. Ionen oder Elektronen) magnetisch abgelenkt werden. Es ist ebenfalls möglich, an das zu beschichtete Substrat negative Spannung anzulegen, um die positiv geladenen Teilchen zu beschleunigen.

Heute werden oft plasmagestützte Methoden, wie z.B. Ionenplattieren, angewendet. Dabei werden insbesondere höherwertigere Metalle auf ein anderes Metall aufgebracht, indem das zu beschichtete Substrat mittels Ionenbeschuss aus dem Plasma gereinigt und anschließend mit einem Metalldampf in Kontakt gebracht wird. Dieser ionisiert teilweise im Plasma und wird durch eine Vorspannung am vorgeheizten Substrat auf dessen Oberfläche beschleunigt und als eine dünne Schicht abgeschieden.

Eine Vorrichtung zum kontinuierlichen Verzinken von kaltgewalztem Stahlband ist aus der DE 30 35 000 A1 bekannt. Die Vorrichtung ermöglicht wahlweise eine Herstellung von beidseitig oder einseitig verzinktem Band. Dafür sind parallel zu einander eine Tauchverzinkungsvorrichtung und eine Vakuumverdampfungseinrichtung angeordnet. In der Tauchverzinkungsvorrichtung wird das Band beidseitig verzinkt, während für eine einseitige Verzinkung die Tauchverzinkungsvorrichtung außer Betrieb gesetzt und das Band durch die Vakuumverdampfungseinrichtung horizontal durchgeführt wird. Das Zink wird aus der Schmelze verdampft. Der Beschichtungsgrad wird dabei durch die Verdampfungsrate und Temperaturerhöhung des Bandes gesteuert. Für eine 1 mm dicke Zinkschicht bei einer einseitigen Beschichtung mittels PVD wird beispielsweise eine Temperaturerhöhung von 71 °C eingestellt.

Eine Methode zur Verbesserung eines bereits verzinkten Stahlbleches wird in der DE 38 00 885 C1 offenbart. Dabei wird ein verzinktes Stahlblech durch eine Anordnung aus einem Vorbehandlungsofen, einem Gastromkühler, einer Druckkammer und zwei Bedampfungskammern horizontal durchgeführt. Jede Blechseite wird einzeln mit Zink bedampft und anschließend thermisch nachbehandelt.

Ein vertikaler Bandlauf ist ebenfalls bekannt. Eine derartige Vorrichtung für eine kontinuierliche vertikale Vakuumbeschichtung wird in der DE 10 2011 085 789 B4 beschrieben. Für diesen Zweck wird eine Transporteinrichtung in einer Beschichtungskammer angeordnet, die die zu beschichteten Substrate in zwei übereinander verlaufenden Transportpfaden an den Beschichtungseinrichtungen vorbei bewegt. Dabei werden zwei Substrate simultan beschichtet.

Eine vertikale Substratausrichtung wird in der US 2014/0302232 A1 beschrieben. Aus der genannten Druckschrift ist ein Beschichtungsverfahren bekannt, bei dem ein Substrat beidseitig beschichtet wird. Dafür werden mehrere Schichten mittels PVD oder CVD auf die Substratoberfläche abgeschieden. Dabei handelt es sich um leitende Materialien für Batterieanwendungen, wie beispielsweise Lithium, amorphes Silizium oder Silizium mit Nanowires. Das zu beschichtete Substrat wird vertikal bewegt und das verdampfte Beschichtungsmaterial wird mittels eines Gasverteilungsmechanismus derart eingeleitet, dass das Substrat an mehreren Stellen beidseitig Kontakt mit dem Beschichtungsmaterial hat. Das Substrat (Blech, Streifen) wird von beiden Seiten eingespannt und seine Bewegung und somit der Beschichtungsgrad werden mittels einer Spannvorrichtung kontrolliert.

Bei den konventionellen kontinuierlichen PVD-Verfahren ist von Nachteil, dass der Durchsatz gering und die Schichthomogenität über Bandlänge und Bandbreite nur mit einem hohen technischen Aufwand erreichbar ist. Durch die Streubedampfung treten hohe Materialverluste und ein hoher Wartungsaufwand auf, welche mit großem Kostenaufwand verbunden sind.

Aus der DD 160 563 ist ein Zinkverdampfer bekannt, dessen Aufgabe darin besteht, die Bildung von Zinkoxid weitestgehend zu verhindern. Zu diesem Zweck wird ein Verdampfer mit einem integrierten Vorschmelzgefäß geschaffen. Im Inneren des Verdampfers wird der Innendruck erhöht. Die zum Vorschmelzen benötigte Energie wird über eine zwischen dem Verdampfer und dem Vorschmelzgefäß eingerichtete Trennwand als Kondensationswärme des Zinkdampfs zugeführt. Die Dampfaustrittsöffnung wird geschlossen und die flüssige Schmelze, die sich im Vorschmelzgefäß befindet, läuft aus diesem über einen Überlauf ab. Das verbleibende Zinkoxid wird nach dem Öffnen der Dampfaustrittsöffnung verdampft. Anschließend wird ein neuer Beschichtungszyklus gestartet.

Aus der WO 2015/015237 A1 ist eine Jet-Verdampfung von Zink bekannt. Die Verdampfungseinrichtung ist in der Beschichtungskammer derart angeordnet, dass beide Prozesse in einer Kammer ablaufen. Dafür werden definierte Druckdifferenzen zwischen der Verdampfer- und der Beschichtungskammer benötigt. Das Verhältnis beider Drücke sollte so eingestellt werden, dass es zwischen 2·10⁻³ und 5,5·10⁻² liegt.

Ein Verfahren, bei dem die Verdampfung und Beschichtung ebenfalls in eine Kammer ablaufen ist aus der DE 44 42 733 A1 bekannt. Hierbei handelt es sich um eine Integration von Verdampfertiegel und Kondensationskanal. Der Kondensationskanal wird derart angeordnet, dass er ein unmittelbarer Bestandteil des Verdampfertiegels bzw. -deckels ist.

Aus der EP 0 477 474 A1 ist eine Vakuum-Aufdampfvorrichtung bekannt, welche einen Verdampfungstank zum Halten und Verdampfen von Aufdampfmaterial, eine Haube, die die Oberseite des Verdampfungsbehälters abdeckt und sich bis zu seiner Außenseite in horizontaler Richtung erstreckt, Einlaß- und Auslaßöffnungen für ein aufzudampfendes Band, die in der Haube geöffnet sind, umfasst. Zudem ist ein Vakuumbehälter vorgesehen, welcher den Verdampfungstank und die Haube vollständig abdeckt. Aufdampfe und Abscheidung erfolgen innerhalb der Haube gleichzeitig auf die Vorder- und Rückseiten des aufzudampfenden Bandes. Vorzugsweise umfasst die Vorrichtung zum Aufdampfen im Vakuum außerdem eine Vorrichtung zur Steuerung der Dampfmenge. Weiterer relevanter Stand der Technik ist in der Druckschrift JP S59 177370 A offenbart.

Bei einer Jet-Verdampfung ist von Nachteil, dass die Zink-Schichthaftung auf Grund einer sehr hohen lokalen Beschichtungsrate oft mangelhaft ist. Um dies zu vermeiden, ist eine Zwischenschicht oder Haftschicht erforderlich, welche eine zusätzliche Verdampferquelle oder einen zusätzlichen Durchlauf durch die Anlage erfordert und mit einem technischen sowie Kostenaufwand verbunden ist.

Die Erfindung ist durch die unabhängigen Ansprüche 1 und 9 definiert.

Aufgabe der Erfindung ist es, ein Abscheideverfahren zu schaffen, mit dem metallische Werkstoffe, insbesondere auf Zinkbasis, auf Metallbänder, insbesondere Stahlbändern, effektiv und ressourcenschonend abgeschieden werden können.

Die Aufgabe wird mit dem Verfahren mit den Merkmalen des Anspruchs 1 gelöst.

Vorteilhafte Weiterbildungen sind in den hiervon abhängigen Unteransprüchen gekennzeichnet.

Die Erfindung sieht vor, dass in einer Beschichtungsvorrichtung eine Vakuumkammer bzw.

Beschichtungskammer angeordnet ist. In der Beschichtungskammer wird ein flüssiger beheizter Metallstrom erzeugt, beispielsweise ein Zinkstrom, welcher anschließend sehr nah am Substrat teilweise verdampft wird. Das Substrat wird mittels des entstandenen Metall- bzw. Zinkdampfes beschichtet. Die nicht verbrauchte Metallschmelze bzw. Zinkschmelze wird aufgefangen und zurück in den Umlauf geführt. Die zwangsläufig entstehenden Zinkoxide und Schlacken können ausgetragen werden, so dass sie nicht im Umlauf verbleiben.

"Metallschmelze" und "Metallstrom" können synonym verwendet werden. Bei "Metallschmelze" liegt der Fokus auf dem flüssigen Aggregatzustand, der "Metallstrom" bezeichnet die über eine Trageeinrichtung herabfließende Metallschmelze. Im Gegensatz zum Stand der Technik, bei welchem oftmals aus Draht in der Kammer die Schmelze erzeugt wird, wird bei der Erfindung die Schmelze flüssig in die Kammer eingebracht. Dadurch kann vorteilhafterweise die Menge an Verunreinigungen wie Oxidverunreinigung oder Einbringung von Ziehölen etc. minimiert werden.

Die Metallschmelze kann beispielsweise aus Zink bestehen und Aluminium, Magnesium und/oder Silizium enthalten. Ebenso kann sie aus Aluminium bestehen und weitere Elemente enthalten.

Die flüssige Metallschmelze wird thermisch aus festem Metall erzeugt, welches bevorzugt einen Schmelzpunkt unter 800 °C, besonders bevorzugt unter 600 °C aufweist. Die Metallschmelze wird in die Beschichtungskammer eingeführt und der Gravitation folgend an einer Trageeinrichtung herunter geführt. Überschüssige Metallschmelze kann aufgefangen und über Pumpeinrichtungen im Kreislauf geführt werden.

Der abwärts fließende Metallstrom kann thermisch verdampft werden. Deshalb ist es von Vorteil, wenn die Trageeinrichtung und/oder der Metallstrom beheizt wird. Dabei kann es sich um eine direkte und/oder indirekte Erwärmung handeln.

Als eine indirekte Erwärmung wird beispielsweise eine Erwärmung über Heizfelder oder eine direkte Beheizung der Trageeinrichtung bezeichnet.

Als eine direkte Erwärmung wird beispielsweise eine konduktive Erwärmung des Schmelzstromes bezeichnet. Dabei kann eine elektrische Kontaktierung am oberen und unteren Ende des metallischen Schmelzstromes erfolgen, durch die Durchleitung von einem elektrischen Strom kann das flüssige Metall zusätzlich erhitzt werden.

Es ist von Vorteil, wenn die Trageeinrichtung verstellbar angeordnet ist, so dass die Neigung und/oder der Abstand zum Substrat beliebig eingestellt werden können. So können die Strömungsgeschwindigkeit des flüssigen Metalls und die Beschichtungsrate eingestellt werden.

Zudem ist es vorteilhaft, wenn die Trageeinrichtung eine Oberflächenbeschaffenheit (Rauheit, Welligkeit) aufweist mit der das Strömungsbild (laminar, turbulent) eingestellt werden kann. Dies dient ebenfalls der Einstellung der Strömungsgeschwindigkeit und der Beschichtungsrate. In einer Ausführungsform ist es von Vorteil, den Metallstrom so zu steuern, dass er über die gesamte Breite oder eine Teilbreite der Trageeinrichtung fließt.

Erfindungsgemäß ist es von Vorteil, wenn die Beschichtungsvorrichtung eine Plasmaeinkopplung umfasst. Durch Positionierung der Plasmaeinkopplung im unteren-, mittleren- oder oberen Bereich oder über den gesamten Bereich der Beschichtungszone kann der Beschichtungsprozess durch das Plasma und dem zusätzlichen generierten Verdampfungsstrom beeinflusst werden, sodass es zu einer besseren Schichthaftung auf dem Substrat, einer feineren Mikrostruktur der Schicht oder einer porenfreien Schichtausbildung kommen kann. Das generierte Plasma kann beispielsweise zur Einstellung folgenden Abscheidemerkmale herangezogen werden:
- Plasmaeinkopplung im Einlaufbereich des Substrates: Aufbringung erster Atomlagen nach Eintritt des Substrates bzw. Stahlbandes in die Beschichtungszone und damit Herstellung einer Haftschicht
- Feinabstimmung der Verdampfung, schnelle und genaue Einstellung der Schichtdicke
- Verdampfung von zusätzlichen Werkstoffen die beispielsweise in Draht- oder Bandform ausgeführten sind und direkt in der Plasmaeinkopplung verdampft werden.
- Zwei Beschichtungszonen, 1. Zone für eine Haftschicht (z.B. Cu, Cr o.ä.) und 2. Zone für die gewünschte Schicht (z.B. Zn, höhere Auflage)

Des Weiteren kann vorteilhafterweise neben der bereits erwähnten Einstellung der Schichtdicke die Regelung der Plasmaeinkopplung derart gewählt werden, dass damit auch lokal die Schweisseignung insbesondere Punktschweisseignung verbessert werden kann. Beispielsweise lassen sich Bereiche am Band welche später als Anbindungsbereich vorgesehen sind speziell mit einer geringeren Plasmaeinkopplung oder Abschaltung der Plasmaeinkopplung behandeln. Der große Vorteil der Plasmaregelung ist deren dynamische Einstellbarkeit so dass im Gegensatz zu eher stationären Systemen wie Platten eine sehr rasche Regelung vorgenommen werden kann, dadurch kann eine Einstellung längs und/oder quer zur Bandlaufrichtung vorgenommen werden.

Die Regelung der Plasmaeinkopplung erfolgt elektrisch, beispielsweise über die Regelung des Stroms bzw. der angelegten Spannung. Die Spannung wird über Elektroden angelegt, die in einem Plasmagenerator vorgesehen sind. Der Plasmagenerator, in dem das Plasma erzeugt wird, umfasst mindestens eine Elektrode und mindestens ein Filament. Sind mehrere Filamente vorhanden, ist für jedes Filament eine separate Stromversorgung vorgesehen, so dass jedes Filament separat steuerbar ist. Separat steuerbar bedeutet, dass die angelegte Spannung bei jedem Filament unabhängig von anderen Filamenten unterschiedlich eingestellt werden kann.

Mit den separat steuerbaren Filamenten ist es möglich, ein Plasma lokal in unterschiedlichen Stärken zu erzeugen. Eine lokale Plasmaerzeugung bedeutet, dass in einigen Bereichen das Plasma mit einer stärkeren Intensität und in einigen mit einer schwächeren Intensität erzeugt werden kann.

Durch die Intensität des Plasmas ist die Schichtdicke der Beschichtung, beispielsweise einer Zink- oder Kupferbeschichtung, regulierbar.

Die Steuerung erfolgt hierbei rasch, beispielsweise im Millisekundenbereich. Damit ist bei einer Bandlaufgeschwindigkeit von beispielsweise 3 m/s eine Regelung am Band im Subzentimeterbereich möglich.

Die Einstellung bzw. Regelung über die Bandbreite erfolgt durch die Anordnung des mindestens einen Filaments. Dies bedeutet, dass die Regelung in Abhängigkeit der Elektroden und insbesondere in den Abständen, in welchen diese angeordnet sind, entsprechend vorgenommen wird.

Hierfür wird das mindestens eine Filament in der Plasmaeinkopplung in einer Beschichtungskammer substratseitig angeordnet, so dass das erzeugte Plasma mindestens auf einer Substartseite auftrifft. Sind mehrere Filamente vorhanden, werden sie über die Bandbreite verteilt angeordnet, so dass ein gewünschtes Plasmaaktivierungsmuster erreicht wird. Dies kann beispielsweise durch eine Anordnung im Abstand von 5 bis 10 cm je Elektrode erreicht werden. Dies ist vorteilhaft, wenn die minimale Ausstreckung eines Plasmas in der Breite ein Bereich von 5 bis 10 cm ist.

Die Filamente sind fest angeordnet. Bewegliche Teile in der Plasmaeinkopplung oder Relativbewegungen in Bezug auf Substrat werden nicht vorgenommen. Dies würde die Gefahr einer Kollision oder Beschädigung erhöhen.

Mit der Regelung der Plasmaeinkopplung kann eine Beschichtung je nach Intensität des Plasmas auf eine Schichtdicke von beispielsweise 2 µm (minimale Intensität des Plasmas) bis beispielsweise 15 µm (volle Intensität des Plasmas) lokal bzw. bandseitig geregelt werden.

In einer weiteren Ausführungsform können durch die Plasmaquelle auch zusätzlich hochschmelzende Metalle wie z. B. Ti, Cr, Si in einem Plasma mit verdampft werden. Die Zufuhr dieser Werkstoffe kann in Draht- oder Bandform erfolgen.

Somit betrifft die Erfindung ein
Verfahren zum kontinuierlichem Abscheiden von metallischen Schichten aus einer Dampfphase auf metallischen Substraten, bevorzugt Metallbändern, insbesondere Stahlbändern, wobei die Abscheidung in einer Beschichtungskammer einer Beschichtungsvorrichtung unter Vakuum in eine Bandlaufrichtung durchgeführt wird, indem ein Substrat im Wesentlichen vertikal, mit einer Abweichung des Substrats vom Lot von 0 bis 10 °, durch die Beschichtungskammer durchgeführt wird, wobei zumindest eine Trageeinrichtung in der Beschichtungskammer vorhanden ist, welche benachbart zu einer Oberfläche des Substrates angeordnet ist, wobei ein zu verdampfendes Metall in einem Aufschmelzbecken eingeschmolzen wird und ein flüssiger Metallstrom in die Beschichtungskammer aus einer Umlaufanordnung eingeführt und über die Trageeinrichtung geführt wird, , wobei die Trageeinrichtung temperiert wird, so dass das flüssige Metall im Vakuum verdampft und auf dem metallischem Substrat durch Kondensation und/oder Sublimation abgeschieden wird, wobei das Aufschmelzbecken in der Umlaufanordnung außerhalb der Beschichtungskammer angeordnet wird, wobei zwischen dem Substrat und der Trageeinrichtung ein Plasma eingekoppelt wird.

Bei einer vorteilhaften Ausführungsform wird das flüssige Metall über zwei Trageeinrichtungen beidseitig des Substrats geführt, wobei das Metall mittels zumindest einer der Trageinrichtungen verdampft wird, sodass die Trageinrichtung als Verdampfungseinrichtung ausgebildet ist.

Bei einer weiterhin vorteilhaften Ausführungsform wird eine Trageeinrichtung verwendet, welche als ein Netz, Vlies, Kettennetz oder eine Platte ausgebildet ist.

Es ist vorteilhaft, wenn eine Trageeinrichtung verwendet wird, welche der Breite des Substrates entspricht oder breiter ist.

Zudem ist es vorteilhaft, wenn die Trageeinrichtung sich über die gesamte Länge des Substrats erstreckt.

Es ist ebenfalls vorteilhaft, wenn die Fließgeschwindigkeit des flüssigen Metalls entlang der Trageeinrichtung über die Oberflächenbeschaffenheit, insbesondere eine Rauheit und/oder eine Welligkeit, beeinflusst wird.

Vorteilhafterweise wird eine Trageeinrichtung verwendet, welche eine konkave Fläche zur Breitseite des Substrats aufweist.

Bei einer vorteilhaften Ausführungsform wird am unteren und/oder oberen Ende der Trageeinrichtung die Neigung und oder der Abstand der Trageinrichtung zum Substrat mittels zumindest einer Verstelleinrichtung verstellt.

. Bei einer vorteilhaften Ausführungsform wird die Intensität des erzeugten Plasmas dynamisch längs und/oder quer zur Bandlaufrichtung geregelt.

Durch die Regelung der Plasmaeinkopplung kann vorteilhafterweise die Abscheidungsrate des Beschichtungsmaterials am Band dynamisch geregelt werden, d.h. längs und oder quer zur Bandlaufrichtung lokal einstellbar sein. Eine erhöhte Plasmaeinkopplung führt zu einer erhöhten Abscheiderate.

Vorteilhafterweise kann durch die Regelung eine sogenannte Differenzverzinkung vorgenommen werden, wodurch je Bandseite eine unterschiedliche Beschichtungsdicke eingestellt werden kann.

Erfindungsgemäß wird das flüssige Metall im Umlauf geführt, wobei der flüssiger Metallstrom an der Trageeinrichtung herunter geführt wird, das nicht verbrauchte Metall aufgefangen wird und dem Umlauf wieder zugeführt wird. Dies vermindert nicht nur den Materialverbrauch sondern kann darüber hinaus die Menge an Verunreinigungen minimieren.

Die Erfindung betrifft ebenfalls eine Vorrichtung zur Durchführung eines oben beschriebenen Verfahrens, wobei eine Beschichtungskammer vorgesehen ist, welche zumindest eine Trageeinrichtung umfasst, wobei die Trageeinrichtung benachbart zu einer Oberfläche des Substrats angeordnet ist, wobei eine Umlaufanordnung für einen flüssigen Metallstrom außerhalb der Beschichtungskammer angeordnet ist, wobei die Umlaufanordnung ein Aufschmelzbecken umfasst, wobei die Beschichtungskammer mit der Umlaufanordnung über ein Zufuhrkanal und ein Abströmkanal in Verbindung steht, wobei zwischen dem Substrat (9) und der Trageeinrichtung eine Plasmaeinkopplung angeordnet ist, wobei die Beschichtungskammer mindestens einen Auffangbehälter und mindestens eine Umlaufanordnung für den flüssigen Metallstrom umfasst, wobei in der Beschichtungskammer das kontinuierliche Abscheiden von metallischen Schichten aus einer Dampfphase auf metallischen Substraten unter Vakuum durchführbar ist, indem ein Substrat im Wesentlichen vertikal, mit einer Abweichung des Substrats vom Lot von 0° bis 10°, durch die Beschichtungskammer in einer Bandlaufrichtung durchführbar ist, wobei über die Trageeinrichtung ein flüssiger Metallstrom führbar ist, sodass das flüssige Metall im Vakuum verdampfbar ist und auf dem metallischen Substrat durch Kondensation und/oder Sublimation abscheidbar ist, wobei das Aufschmelzbecken in der Umlaufanordnung außerhalb der Beschichtungskammer angeordnet ist.

Es ist vorteilhaft wenn die Trageeinrichtung bezüglich ihrer Neigung und/oder bezüglich des Abstandes zum Substrat einstellbar ausgebildet ist.

Es ist ebenfalls vorteilhaft, wenn an der Trageeinrichtung mindestens ein Zufuhrkanal und ein Abströmkanal vorhanden sind.

Erfindungsgemäß umfasst die Beschichtungskammer mindestens einen Auffangbehälter und mindestens eine Umlaufanordnung für den flüssigen Metallstrom.

Bei einer weiterhin vorteilhaften Ausführungsform sind der Zufuhrkanal und der Abströmkanal so an der Trageinrichtung angeordnet, dass der Metallstrom der Schwerkraft folgend an der Trageinrichtung fließend angeordnet ist.

Bei einer besonders vorteilhaften Ausführungsform ist zwischen dem Substrat und der Trageeinrichtung eine Plasmaeinkopplung angeordnet ist, welche dynamisch regelbar ist.

Die Erfindung wird anhand einer Zeichnung beispielhaft erläutert. Es zeigen dabei:
Figur 1: Eine erfindungsgemäße Beschichtungsvorrichtung;
Figur 2: Eine Beschichtungsvorrichtung mit zusätzlicher Plasmaeinkopplung;
Figur 3: Eine Trageeinrichtung mit veränderlichem Abstand zum Substrat;
Figur 4: Eine Beschichtungsvorrichtung mit integriertem flüssigem Metallschmelzekreislauf.

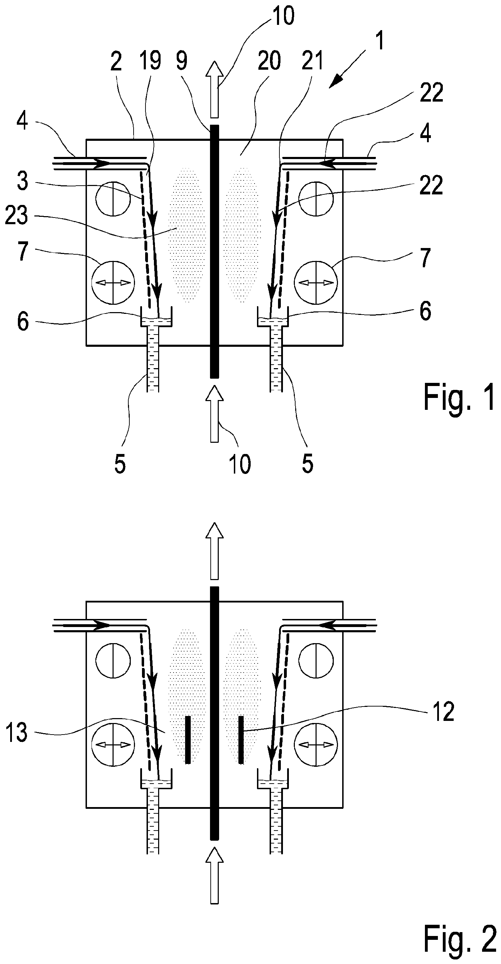

Die Figuren 1 bis 4 zeigen eine erfindungsgemäße Beschichtungsvorrichtung 1. Die Beschichtungsvorrichtung 1 umfasst eine Beschichtungskammer 2 und mindestens zwei Vakuumschleusen. In der Beschichtungskammer 2 ist mindestens eine Trageeinrichtung 3 angeordnet. An der Trageeinrichtung 3 sind mindestens ein Zufuhrkanal 4 und ein Abströmkanal 5 vorhanden. Außerdem umfasst die Beschichtungskammer 2 mindestens einen Auffangbehälter 6, mindestens eine Verstelleinrichtung 7 und mindestens eine Umlaufanordnung für den flüssigen Metallstrom 8.

Die Zufuhr bzw. Ausfuhr des Substrates 9 in die Beschichtungskammer 2 hinein und aus der Beschichtungskammer 2 heraus erfolgt über Vakuumschleusen. Die Vakuumschleusen sind außerhalb der Beschichtungskammer 2 angeordnet. Das Substrat 9 wird entlang einer Substratbeförderungsrichtung 10 im Wesentlichen vertikal durch die Beschichtungskammer 2 gefördert. "Im Wesentlichen vertikal" bedeutet, dass die Abweichung des Substrats vom Lot 0 bis 10 °, bevorzugt 0 bis 5 ° bevorzugt 0 bis 2° beträgt.

Es ist vorteilhaft, wenn das Substrat 9, insbesondere ein Stahlband, vertikal durch die Beschichtungskammer 2 durchgeführt wird.

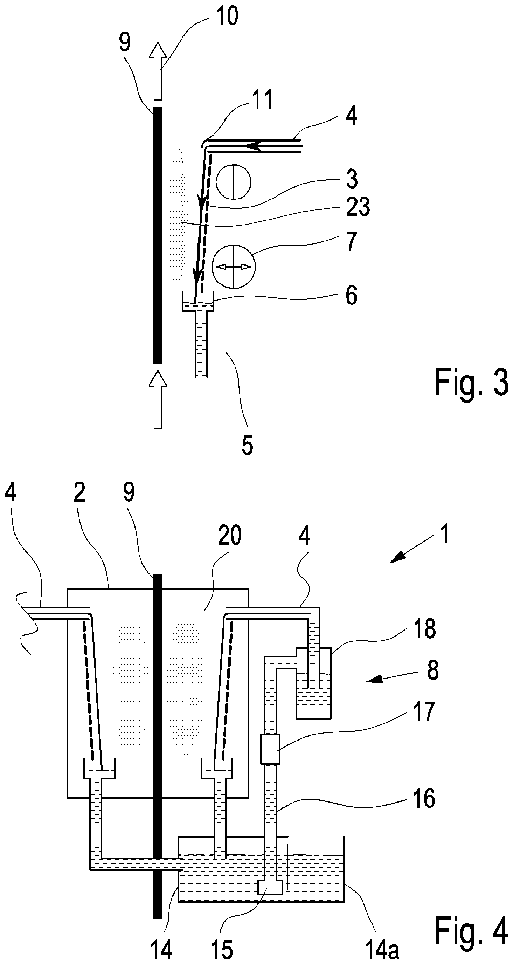

In einer möglichen Ausführungsform ist beidseitig vom Substrat 9 jeweils eine vertikal ausgerichtete Trageeinrichtung 3 verstellbar angeordnet. Die Trageeinrichtung 3 kann beispielsweise als ein Netz, Kettennetz, Vlies oder eine Platte ausgebildet sein. Weiters kann die Trageeinrichtung 3 mit konkaven oder parabolischen Flächen in Substratrichtung ausgeführt sein. Dies kann zu einer gleichmäßigeren Beschichtung über die Bandbreite führen. Die Neigung und der Abstand der Trageeinrichtung 3 zum Substrat können mittels einer Verstelleinrichtung 7 verstellt werden. Die Verstelleinrichtung 7 kann am unteren und/oder oberen Ende der Trageeinrichtung 3 angeordnet sein. Ein mittels der Verstelleinrichtung 7 verringerter Abstand zwischen der Trageeinrichtung 3 und dem Substrat 9 ist in Figur 3 dargestellt.

Das untere Ende der Trageeinrichtung 3 befindet sich in einem Auffangbehälter 6, welcher mit einem Abströmkanal 5 verbunden ist.

Am oberen Ende der Trageeinrichtung 3 ist ein insbesondere horizontal verlaufender Zufuhrkanal 4 angeordnet. Der Übergang von horizontal zu vertikal erfolgt über ein Verbindungselement 11. Das Verbindungselement 11 kann beispielsweise als eine Düse, ein Führungsblech, eine Wehr o.Ä. ausgebildet sein (Figur 3).

In einer weiteren Ausführungsform kann zwischen dem Substrat 9 und der Trageeinrichtung 3 eine Plasmaeinkopplung 12 angeordnet sein. Es ist besonders vorteilhaft, wenn sich die Plasmaeinkopplung 12 im unteren- 13, mittleren- oder oberen Bereich oder gesamten Bereich der Trageeinrichtung 3 befindet, je nachdem welches Abscheidemerkmal erzielt werden soll. Es können folgende Abscheidemerkmale erzielt werden:
- Plasmaeinkopplung im unteren Bereich: Aufbringung erster Atomlagen nach Eintritt des Substrats 9 in den Beschichtungsbereich und damit Herstellung einer Haftschicht (bei Bandlaufrichtung von oben nach befindet sich die Plasmaeinkopplung entsprechend oben);
- Plasmaeinkopplung im gesamten Bereich: Feinabstimmung der Verdampfung, genaue und schnelle Einstellung der Schichtdicke ;
- Plasmaeinkopplung dort wo zusätzlich Werkstoffe z.B. in Draht- oder Bandform in einem Plasma verdampft werden sollen.

In Figur 4 ist eine erfindungsgemäße Beschichtungsvorrichtung 1 mit einer Umlaufanordnung für den flüssigen Metallstrom 8 beispielhaft dargestellt. Die Umlaufanordnung 8 umfasst mindestens einen Zufuhrkanal 4, mindestens einen Abströmkanal 5, ein Auffang- und Aufschmelzbecken 14, mindestens eine Pumpe 15, eine Leitung 16 für die Schmelze, eine Wärmequelle 17 zum Nachwärmen der Schmelze und ein Ausgleichsgefäß 18.

Das Auffang- und Aufschmelzbecken 14 kann ein Vorschmelzbecken 14a enthalten. In dem Vorschmelzbecken 14a kann festes Metall nachchargiert werden, welches dort geschmolzen wird. Das Vorschmelzbecken ist durch eine Sperrwand mit Öffnung unterhalb der Oberflächen der Metallschmelzen vom Auffang- und Aufschmelzbecken 14 getrennt, sodass sie als kommunizierende Gefäße wirken. Vorteil des Vorschmelzbeckens ist die Homogenisierung der Metallschmelze sowie die leichte Abtrennung von Schlacken, die in als Verunreinigung in den Nachchargierblöcken oder -granulaten enthalten sein können und einfach von der Oberfläche der Metallschmelze im Vorschmelzbecken 14a entfernt werden können.

Der Zufuhrkanal 4 verläuft horizontal und verbindet die Umlaufanordnung 8 mit der Beschichtungskammer 2. Die Zufuhröffnung 19 des Zufuhrkanals 4 befindet sich im Inneren 20 der Beschichtungskammer 2. Unterhalb der Zufuhröffnung 19 ist die Trageeinrichtung 3 vertikal angeordnet. Über das Verbindungselement 11 erfolgt der Übergang von der horizontalen in die vertikale Ausrichtung. Das untere Ende der Trageeinrichtung 3 befindet sich im Auffangbehälter 6. Vom Auffangbehälter 6 aus geht der Abströmkanal 5, welches den Auffangbehälter 6 und das Auffang- und Aufschmelzbecken 14 verbindet. Im Inneren des Auffang- und Aufschmelzbeckens 14 ist die Pumpe 15 angeordnet. Bei der Pumpe 15 handelt es sich um eine Pumpe für flüssige Metalle und deren Legierungen, z.B. bei Zink um eine herkömmliche Zinkpumpe. Die Pumpe 15 und das Ausgleichsgefäß 18 für die flüssige Schmelze sind mittels einer Leitung 16 verbunden. Die Leitung 16 ist isoliert und die Metallschmelze mittels der Wärmequelle 17 beheizt.

Bei der Wärmequelle 17 kann es sich beispielsweise um einen elektromagnetischen Induktor handeln.

Der Schmelzumlauf wird dadurch geschlossen, dass der Zufuhrkanal 4 in das Innere des Ausgleichsgefäßes 18 ragt. Somit verbindet der Zufuhrkanal 4 das Innere des Ausgleichsgefäßes 18 mit dem Inneren 20 der Beschichtungskammer 2.

Die erfindungsgemäße Abscheidung von metallischen Werkstoffen erfolgt, indem die flüssige Metallschmelze an der Trageeinrichtung 3 herunter läuft und dabei erwärmt wird. Durch die Erwärmung des Metallstroms 21 wird ein Metalldampf 23 erzeugt. Die Verdampfung des Metalls findet nah am Substrat 9 statt. Zwischen der Substratoberfläche und dem Metalldampf 23 besteht ein Temperaturgefälle, so dass die Substratoberfläche eine niedrigere Temperatur als der Metalldampf 23 hat. Die heißen Metallmoleküle treffen auf die Substratoberfläche auf und kondensieren/sublimieren.

Die Haftung der abgeschiedenen Metallschicht kann mittels Plasma erhöht werden. Durch eine zusätzlich angeordnete Plasmaeinkopplung 12 erfahren die ersten Atomschichten auf der Substratoberfläche eine bessere Haftung.

Die Beschichtungsrate kann über die Temperatur der Trageeinrichtung 3 oder des Metallstromes 21 eingestellt werden. Bei höheren Temperaturen werden höhere Schichtdicken erzielt. Niedrigere Temperaturen resultieren in dünneren Schichtdicken und somit niedrigeren Beschichtungsraten.

Die Beschichtungsrate kann ebenfalls durch den Abstand zwischen der Trageeinrichtung 3 und dem Substrat 9 eingestellt werden. Ein verringerter Abstand bzw. die Einkopplung vom Plasma führt zu höheren Beschichtungsraten. Ein größerer Abstand resultiert in niedrigeren Beschichtungsraten.

Die Fließgeschwindigkeit des Metallstroms 22 kann über die Neigung und/oder die Oberflächenbeschaffenheit (Rauheit, Welligkeit) der Trageeinrichtung 3 eingestellt werden. Eine kleine Neigung und/oder eine hohe Oberflächenrauheit können die Fließgeschwindigkeit verlangsamen und das Strömungsbild (turbulent oder laminar) des Metallstroms 21 beeinflussen.

Der nicht verbrauchte Metallstrom 21 wird unten im Auffangbehälter 6 aufgefangen. Aus dem Auffangbehälter 6 fließt die aufgefangene Metallschmelze durch den Abströmkanal 5 entlang der Umlaufrichtung 22 in den Auffang- und Aufschmelzbehälter 14.

Aus dem Auffang- und Aufschmelzbehälter 14 wird das flüssige Metall mittels einer Pumpe 15 nach oben in die Leitung 16 befördert. Metalloxide und Schlacken werden dabei entfernt und gelangen somit nicht in die Leitung 16. Um die Metallschmelze flüssig zu halten, wird die Leitung 16 isoliert und die Schmelze mittels einer Wärmequelle 17, insbesondere mit einem Induktor, beheizt.

Am Ende der Leitung 16 für die Metallschmelze erreicht das flüssige Metall das Ausgleichsgefäß 18.

Der Umlauf wird geschlossen, indem die Metallschmelze aus dem Ausgleichgefäß 18 in den Zufuhrkanal 4 gelangt und anschließend am Ende des Zufuhrkanals 4 durch die Zufuhröffnung 19 austritt. Durch die Einwirkung der Schwerkraft wird der Metallstrom 21 an der Trageeinrichtung 3 nach unten befördert.

Demzufolge fließt der Metallstrom 21 in die Umlaufrichtung 22 ins Vakuum bzw. in das Innere 20 der Beschichtungskammer 2 und aus dem Vakuum heraus bzw. in die Umlaufanordnung 8.

Die Erfindung wird anhand eines Ausführungsbeispiels mit einem Zinküberzug einer Auflagenkenzahl Z200, gemäß DIN EN 10346, beispielhaft erläutert.

Ein Stahlband mit einem Z200-Zinküberzug, welches einer Schichtdicke von 14 µm und einer Bandbreite von 1 m entspricht, wird durch die Beschichtungsvorrichtung 1 befördert. Die Bandgeschwindigkeit liegt bei 3 m/s. Bei diesem Vorgang werden 600 g Zink pro 1 s auf die Stahloberfläche abgeschieden. Damit liegt die Verdampfungsrate des Zinks bei 2160 kg/h.

Um eine gute Benetzung der Trageeinrichtung 3, insbesondere eines Vlieses, zu gewährleisten, soll der Zinkstrom 21 ca. die zehnfache Masse pro Zeiteinheit im Bezug zur verdampften Masse aufweisen. Zu diesem Zweck werden 21,6 Tonnen Zink (das sind ca. 3m³) pro Stunde gepumpt. Dies entspricht 360 kg/min entspricht ca. 50,4 l/min.

Bei dem erfindungsgemäßen Verfahren ist von Vorteil, dass das Verfahren ressourcenschonend abläuft, weil das nicht verbrauchte Zink dem Zinkumlauf wieder zugeführt wird.

Weiterhin ist von Vorteil, dass die störenden Zinkoxide aus dem Verfahren entfernt werden können. Dabei erfolgt die Entfernung ohne großen mechanischen oder Kostenaufwand.

Mit dem erfindungsgemäßen Verfahren sind hohe Beschichtungsraten mit einer gleichmäßigen Beschichtung über die ganze Bandbreite realisierbar. Dabei kann die Bandbreite einfach variiert werden.

Außerdem ist es vorteilhaft, dass eine gute Schichthaftung durch eine plasmaassistierte Bedampfung der mindestens ersten Atomlagen ermöglicht wird. Plasmaassistiert bedeutet, dass zusätzlich zur thermischen Energie mittels eines Plasmas Teilchen aus dem Metallstrom in die Gasphase überführt werden. Die Teilchenergie ist gegenüber der rein thermischen Verdampfung erhöht und bewirkt im Allgemeinen eine bessere Haftung der Schicht auf dem Substrat.

Das erfindungsgemäße Verfahren ermöglicht einen energieeffizienten Beschichtungsprozess, weil durch die erfindungsgemäße Anordnung nur wenig Streuverluste auftreten.

Weiterhin ist es vorteilhaft, dass die Beschichtungsvorrichtung 1 eine einfache Bauform aufweist. Es sind wenig bzw. keine beweglichen Teile vorhanden. Außerdem wird das zu evakuierende Volumen klein gehalten.

Selbstverständlich ist es möglich auch mehrere Beschichtungsvorrichtungen hintereinander anzubringen. Ein modularer Aufbau ist ebenfalls möglich, bei dem zwei oder mehr Beschichtungskammern innerhalb der Beschichtungsvorrichtung angebracht sind, sodass dickere Beschichtungen erzielt werden können und/oder mehrlagige Schichten abgeschieden werden können.

## Patentansprüche

1. Verfahren zum kontinuierlichem Abscheiden von metallischen Schichten aus einer Dampfphase auf metallischen Substraten, bevorzugt Metallbändern, insbesondere Stahlbändern, wobei die Abscheidung in einer Beschichtungskammer (2) einer Beschichtungsvorrichtung (1) unter Vakuum durchgeführt wird, indem ein Substrat (9) im Wesentlichen vertikal, mit einer Abweichung des Substrats vom Lot von 0 bis 10 °, durch die Beschichtungskammer (2) in eine Bandlaufrichtung durchgeführt wird, wobei zumindest eine Trageeinrichtung (3) in der Beschichtungskammer (2) vorhanden ist, welche benachbart zu einer Oberfläche des Substrates (9) angeordnet ist, wobei ein zu verdampfendes Metall in einem Aufschmelzbecken (14) eingeschmolzen wird und ein flüssiger Metallstrom in die Beschichtungskammer (2) aus einer Umlaufanordnung (8) eingeführt und über die Trageeinrichtung (3) geführt wird, wobei die Trageeinrichtung (3) temperiert wird, so dass das flüssige Metall im Vakuum verdampft und auf dem metallischem Substrat (9) durch Kondensation und/oder Sublimation abgeschieden wird, wobei das Aufschmelzbecken (14) in der Umlaufanordnung (8) außerhalb der Beschichtungskammer (2) angeordnet wird, wobei zwischen dem Substrat (9) und der Trageeinrichtung (3) ein Plasma eingekoppelt wird, wobei flüssiges Metall im Umlauf geführt wird, wobei der flüssige Metallstrom (21) an der Trageeinrichtung (3) herunter geführt wird, das nicht verbrauchte Metall aufgefangen wird und dem Umlauf wieder zugeführt wird.

2. Verfahren nach Anspruch 1, **dadurch gekennzeichnet, dass** das flüssige Metall über zwei Trageeinrichtungen (3) beidseitig des Substrats (9) geführt wird, wobei das Metall mittels zumindest einer der Trageinrichtungen (3) verdampft wird, sodass die Trageinrichtung (3) als Verdampfungseinrichtung ausgebildet ist.

3. Verfahren nach einem der vorhergehenden Ansprüchen, **dadurch gekennzeichnet, dass** eine Trageeinrichtung (3) verwendet wird, welche als ein Netz, Vlies, Kettennetz oder eine Platte ausgebildet ist.

4. Verfahren nach einem der vorhergehenden Ansprüchen, **dadurch gekennzeichnet, dass** eine Trageeinrichtung (3) verwendet wird, welche der Breite des Substrates (9) entspricht oder breiter ist.

5. Verfahren nach einem der vorhergehenden Ansprüchen, **dadurch gekennzeichnet, dass** die Fließgeschwindigkeit des flüssigen Metalls entlang der Trageeinrichtung (3) über die Oberflächenbeschaffenheit, insbesondere eine Rauheit und/oder eine Welligkeit, beeinflusst wird.

6. Verfahren nach einem der vorhergehenden Ansprüchen, **dadurch gekennzeichnet, dass** eine Trageeinrichtung (3) verwendet wird, welche eine konkave Fläche zur Breitseite des Substrats aufweist.

7. Verfahren nach einem der vorhergehenden Ansprüchen, **dadurch gekennzeichnet, dass** am unteren und/oder oberen Ende der Trageeinrichtung (3) die Neigung und oder der Abstand der Trageinrichtung (3) zum Substrat (9) mittels zumindest einer Verstelleinrichtung verstellt wird.

8. Verfahren nach einem der vorhergehenden Ansprüchen, **dadurch gekennzeichnet, dass** zwischen dem Substrat (9) und der Trageeinrichtung (3) ein Plasma eingekoppelt wird wobei die Intensität des erzeugten Plasmas dynamisch längs und/oder quer zur Bandlaufrichtung geregelt wird.

9. Vorrichtung zur Durchführung eines Verfahrens nach einem der vorhergehenden Ansprüche, **dadurch gekennzeichnet, dass** eine Beschichtungskammer (2) vorgesehen ist, welche zumindest eine Trageeinrichtung (3) umfasst, wobei die Trageeinrichtung (3) benachbart zu einer Oberfläche des Substrats (9) angeordnet ist, wobei eine Umlaufanordnung für einen flüssigen Metallstrom (8) außerhalb der Beschichtungskammer (2) angeordnet ist, wobei die Umlaufanordnung (8) ein Aufschmelzbecken (14) umfasst, wobei die Beschichtungskammer (2) mit der Umlaufanordnung (8) über ein Zufuhrkanal (4) und ein Abströmkanal (5) in Verbindung steht, wobei zwischen dem Substrat (9) und der Trageeinrichtung (3) eine Plasmaeinkopplung (12) angeordnet ist, wobei die Beschichtungskammer (2) mindestens einen Auffangbehälter (6) und mindestens eine Umlaufanordnung für den flüssigen Metallstrom (8) umfasst, wobei in der Beschichtungskammer (2) das kontinuierliche Abscheiden von metallischen Schichten aus einer Dampfphase auf metallischen Substraten unter Vakuum durchführbar ist, indem ein Substrat (9) im Wesentlichen vertikal, mit einer Abweichung des Substrats vom Lot von 0° bis 10°, durch die Beschichtungskammer (2) in einer Bandlaufrichtung durchführbar ist, wobei über die Trageeinrichtung (3) ein flüssiger Metallstrom führbar ist, sodass das flüssige Metall im Vakuum verdampfbar ist und auf dem metallischen Substrat (9) durch Kondensation und/oder Sublimation abscheidbar ist, wobei das Aufschmelzbecken (14) in der Umlaufanordnung (8) außerhalb der Beschichtungskammer (2) angeordnet ist.

10. Vorrichtung nach Anspruch 9, **dadurch gekennzeichnet, dass** die Trageeinrichtung (3) bezüglich ihrer Neigung und/oder bezüglich des Abstandes zum Substrat einstellbar ausgebildet ist.

11. Vorrichtung nach Anspruch 9 oder 10, **dadurch gekennzeichnet, dass** an der Trageeinrichtung (3) mindestens ein Zufuhrkanal (4) und ein Abströmkanal (5) vorhanden sind.

12. Vorrichtung nach einem der Ansprüche 9 bis 11, **dadurch gekennzeichnet, dass** der Zufuhrkanal (4) und der Abströmkanal (5) so an der Trageinrichtung (3) angeordnet sind, dass der Metallstrom der Schwerkraft folgend an der Trageinrichtung (3) fließend angeordnet ist.

13. Vorrichtung nach einem der Ansprüche 9 bis 12, **dadurch gekennzeichnet, dass** zwischen dem Substrat (9) und der Trageeinrichtung (3) eine Plasmaeinkopplung (12) angeordnet ist wobei die Intensität des erzeugten Plasmas dynamisch längs und/oder quer zur Bandlaufrichtung regelbar ist.

## Claims

1. Method for the continuous deposition of metallic layers from a vapour phase onto metallic substrates, preferably metal strips, in particular steel strips, wherein the deposition is carried out in a coating chamber (2) of a coating device (1) under vacuum, in which a substrate (9), essentially vertically with a deviation of the substrate from the perpendicular of 0 to 10 °, is carried through the coating chamber (2) in a strip running direction, wherein at least one support structure (3) is present in the coating chamber (2), which is arranged adjacent to a surface of the substrate (9), wherein a metal to be evaporated is melted down in a melt-down basin (14) and a liquid metal flow is carried into the coating chamber (2) out of a circulation arrangement (8) and carried over the support structure (3), wherein the support structure (3) is tempered, so that the liquid metal is evaporated in the vacuum and deposited onto the metallic substrate (9) by condensation and/or sublimation, wherein the melt-down basin (14) in the circulation arrangement (8) is arranged outside the coating chamber (2), wherein a plasma is coupled between the substrate (9) and the support structure (3), wherein liquid metal is carried in circulation, wherein the liquid metal flow (21) on the support structure (3) is carried downwards, the non-utilised metal is collected and supplied back into circulation.

2. Method according to Claim 1, **characterised in that** the liquid metal is carried over two support structures (3) on both sides of the substrate (9), wherein the metal is evaporated by means of at least one of the support structures (3), so that the support structure (3) is designed as an evaporation structure.

3. Method according to one of the preceding claims, **characterised in that** a support structure (3) is used, which is designed as a net, web, chain mesh or plate.

4. Method according to one of the preceding claims, **characterised in that** a support structure (3) is used, which has the same or is wider than the width of the substrate (9).

5. Method according to one of the preceding claims, **characterised in that** the flow rate of the liquid metal along the support structure (3) is influenced through the surface quality, in particular a roughness and/or a waviness.

6. Method according to one of the preceding claims, **characterised in that** a support structure (3) is used, which has a concave face for the broad side of the substrate.

7. Method according to one of the preceding claims, **characterised in that** at the lower and/or upper end of the support structure (3) the inclination and or the distance of the support structure (3) to the substrate (9) is adjusted by means of at least one adjustment structure.

8. Method according to one of the preceding claims, **characterised in that** a plasma is coupled between the substrate (9) and the support structure (3), wherein the intensity of the produced plasma is regulated dynamically lengthwise and/or crosswise to the strip running direction.

9. Assembly for carrying out a method according to one of the preceding claims, **characterised in that** a coating chamber (2) is provided, comprising at least one support structure (3), wherein the support structure (3) is arranged adjacent to a surface of the substrate (9), wherein a circulation arrangement for a liquid metal flow (8) is arranged outside the coating chamber (2), wherein the circulation arrangement (8) comprises a melt-down basin (14), wherein the coating chamber (2) is connected to the circulation arrangement (8) via a supply channel (4) and an outflow channel (5), wherein a plasma coupling (12) is arranged between the substrate (9) and the support structure (3), wherein the coating chamber (2) comprises at least one collection vessel (6) and at least one circulation arrangement for the liquid metal flow (8), wherein the continuous deposition of metallic layers from a vapour phase onto metallic substrates under vacuum can be carried out in the coating chamber (2), whereby a substrate (9), essentially vertically with a deviation of the substrate from the perpendicular of 0 ° to 10 °, can be carried through the coating chamber (2) in a strip running direction, wherein a liquid metal flow can be carried over the support structure (3), so that the liquid metal can be evaporated in the vacuum and can be deposited onto the metallic substrate (9) by condensation and/or sublimation, wherein the melt-down basin (14) in the circulation arrangement (8) is arranged outside the coating chamber (2).

10. Apparatus according to Claim 9, **characterised in that** the support structure (3) is designed to be settable in relation to its inclination and/or in relation to the distance to the substrate.

11. Apparatus according to Claim 9 or 10, **characterised in that** at least one supply channel (4) and one outflow channel (5) are present on the support structure (3).

12. Apparatus according to one of Claims 9 to 11, **characterised in that** the supply channel (4) and the outflow channel (5) are arranged on the support structure (3) such that the metal flow is fluidly arranged following gravity on the support structure (3).

13. Apparatus according to one of Claims 9 to 12, **characterised in that** a plasma coupling (12) is arranged between the substrate (9) and the support structure (3), wherein the intensity of the produced plasma can be regulated dynamically lengthwise and/or crosswise to the strip running direction.

## Revendications

1. Procédé de dépôt continu de couches métalliques en phase vapeur sur des substrats métalliques, de préférence des bandes métalliques, en particulier des bandes d'acier, le dépôt étant effectué dans une chambre de revêtement (2) d'un dispositif de revêtement (1) sous vide par guidage d'un substrat (9) sensiblement verticalement, avec une déviation du substrat par rapport à la verticale de l'ordre de 0 à 10°, à travers la chambre de revêtement (2) dans un sens de défilement de la bande, au moins un dispositif porteur (3) étant disposé dans la chambre de revêtement (2), lequel est situé dans le voisinage d'une surface du substrat (9), un métal à évaporer étant fondu dans un bassin de fusion (14) et un flux de métal liquide étant introduit dans la chambre de revêtement (2) à partir d'un système de circulation (8) puis guidé au-dessus du dispositif porteur (3), la température du dispositif porteur (3) étant régulée, de telle sorte que le métal liquide est évaporé sous vide et déposé sur le substrat métallique (9) par condensation et/ou sublimation, le bassin de fusion (14) étant situé dans le système de circulation (8) à l'extérieur de la chambre de revêtement (2), un plasma étant couplé entre le substrat (9) et le dispositif porteur (3), du métal liquide étant guidé dans la circulation, le flux de métal liquide (21) étant guidé vers le bas sur le dispositif porteur (3), le métal non utilisé étant recueilli et renvoyé dans la circulation.

2. Procédé selon la revendication 1, **caractérisé en ce que** le métal liquide est guidé sur deux dispositifs porteurs (3) de part et d'autre du substrat (9), le métal étant vaporisé au moyen d'au moins un des dispositifs porteurs (3), de sorte que le dispositif porteur (3) est conçu comme un dispositif de vaporisation.

3. Procédé selon l'une des revendications précédentes, **caractérisé en ce qu'**on utilise un dispositif porteur (3) qui est conçu comme un filet, un non-tissé, un filet à chaîne ou une plaque.

4. Procédé selon l'une des revendications précédentes, **caractérisé en ce qu'**on utilise un dispositif porteur (3) qui correspond à la largeur du substrat (9) ou qui est plus large.

5. Procédé selon l'une des revendications précédentes, **caractérisé en ce que** la vitesse d'écoulement du métal liquide le long du dispositif porteur (3) est influencée par l'état de surface, en particulier une rugosité et/ou une ondulation.

6. Procédé selon l'une des revendications précédentes, **caractérisé en ce qu'**on utilise un dispositif porteur (3) qui comporte une surface concave vers le côté large du substrat.

7. Procédé selon l'une des revendications précédentes, **caractérisé en ce qu'**à l'extrémité inférieure et/ou supérieure du dispositif porteur (3), l'inclinaison et ou la distance du dispositif porteur (3) par rapport au substrat (9) sont réglées au moyen d'au moins un dispositif de réglage.

8. Procédé selon l'une des revendications précédentes, **caractérisé en ce qu'**un plasma est couplé entre le substrat (9) et le dispositif porteur (3), l'intensité du plasma généré étant régulée de manière dynamique le long et/ou transversalement à la direction de défilement de la bande.

9. Dispositif pour la mise en oeuvre d'un procédé selon l'une des revendications précédentes, **caractérisé en ce qu'**une chambre de revêtement (2) est prévue, laquelle comprend au moins un dispositif porteur (3), le dispositif porteur (3) étant disposé à proximité d'une surface du substrat (9), un système de circulation pour un flux de métal liquide (8) étant disposé à l'extérieur de la chambre de revêtement (2), le système de circulation (8) comprenant un bassin de fusion (14), la chambre de revêtement (2) étant en communication avec le système de circulation (8) par l'intermédiaire d'un canal d'alimentation (4) et d'un canal d'évacuation (5), un couplage de plasma (12) étant disposé entre le substrat (9) et le dispositif porteur (3), la chambre de revêtement (2) comprenant au moins un récipient collecteur (6) et au moins un système de circulation pour le flux de métal liquide (8), le dépôt continu de couches métalliques en phase vapeur sur des substrats métalliques pouvant être effectué sous vide dans la chambre de revêtement (2), en déposant un substrat (9) essentiellement verticalement, avec une déviation du substrat par rapport à la perpendiculaire de 0° à 10°, à travers la chambre de revêtement (2) dans une direction de défilement de la bande, un flux de métal liquide pouvant être guidé par le dispositif porteur (3), de sorte que le métal liquide peut être évaporé sous vide et déposé sur le substrat métallique (9) par condensation et/ou sublimation, le bassin de fusion (14) étant disposé dans le système de circulation (8) à l'extérieur de la chambre de revêtement (2).

10. Dispositif selon la revendication 9, **caractérisé en ce que** le dispositif porteur (3) est conçu de manière à être réglable quant à son inclinaison et/ou la distance par rapport au substrat.

11. Dispositif selon la revendication 9 ou 10, **caractérisé en ce qu'**au moins un canal d'alimentation (4) et un canal d'évacuation (5) sont présents sur le dispositif porteur (3).

12. Dispositif selon l'une des revendications 9 à 11, **caractérisé en ce que** le canal d'alimentation (4) et le canal d'évacuation (5) sont disposés sur le dispositif porteur (3) de telle sorte que le flux de métal est disposé de manière fluide sur le dispositif de porteur (3) en suivant la force de gravité.

13. Dispositif selon l'une des revendications 9 à 12, **caractérisé en ce qu'**un couplage de plasma (12) est disposé entre le substrat (9) et le dispositif porteur (3), l'intensité du plasma généré pouvant être réglée de manière dynamique le long et/ou transversalement à la direction de défilement de la bande.
